**Europäisches Patentamt**

**European Patent Office**

**Office européen des brevets**

(19)

(11) **EP 1 217 724 A1**

(12) **EUROPEAN PATENT APPLICATION**

(43) Date of publication:
   **26.06.2002 Bulletin 2002/26**

(51) Int Cl.⁷: **H03D 3/00**

(21) Application number: **00830838.9**

(22) Date of filing: **21.12.2000**

| (84) Designated Contracting States: **AT BE CH CY DE DK ES FI FR GB GR IE IT LI LU MC NL PT SE TR** Designated Extension States: **AL LT LV MK RO SI** (71) Applicant: **STMicroelectronics S.r.l. 20041 Agrate Brianza (Milano) (IT)** (72) Inventors: • **Ronchi, Marco Cavenago Brianza (Milano) (IT)** | • **Della Torre, Luigi Lissone (Milano) (IT)** • **Zambotti, Paolo 20132 Milano (IT)** • **Vitali, Andrea 24100 Bergamo (IT)** (74) Representative: **Bosotti, Luciano et al c/o Buzzi, Notaro & Antonielli d'Oulx Via Maria Vittoria 18 10123 Torino (IT)** |

(54) **A Quadrature Demodulator and method**

(57)   A digital demodulator for angle-modulated (PM, FM) signals comprises:

- an input module (1, 2) for generating, starting from the modulated signal ($s_{fm}$), a first component ($\cos\phi(n)$) and a second component ($\sin\phi(n)$) in quadrature with respect to one another, said components in quadrature being representative of the real part and of the imaginary part of the modulating signal (s'(t); s"(t)) represented as a complex variable; and
- a processing module (4) able to generate an output signal, calculating the arctangent function of the ratio between said imaginary part and said real part, the output signal identifying the demodulated signal (s'(t); s"(t)).

The processing module (4) acts on the components in quadrature either directly, in the case of phase demodulation, or indirectly, in the case of frequency demodulation. In the latter case, the above-mentioned real component and imaginary component are calculated, respectively, as the sum of the products of each of the components in quadrature with a corresponding delayed version, and as the difference of the cross products of each of the two components in quadrature with a version delayed in time of the other component in quadrature.

The demodulator may be implemented either as a dedicated hardware unit, or else resorting to a computer program product for DSP or microprocessor.

Fig. 2

**EP 1 217 724 A1**

**Description**

Field of the invention

The present invention relates to demodulators for angle-modulated signals, the said term referring in general to frequency-modulated (FM) or phase-modulated (PM) signals.

Description of prior art

In frequency (or phase) modulation, the signal is transmitted modulating the frequency (or the phase) of an appropriate carrier.

In particular, if we define as s'(t) the input signal, A the amplitude of the carrier, $f_c$ the frequency of the latter, and $D_{fm}$ the modulation constant, for the frequency-modulated signal we have the following relation:

$$S_{fm} = A \cdot \cos [2\pi(f_c + D_{fm}s'(t))t]$$

For the phase-modulated signal, if we define as s"(t) the input signal and $D_{pm}$ the modulation constant, we have the following relation:

$$s_{pm} = A \cdot \cos [2\pi f_c t + D_{pm}s''(t)]$$

The two types of modulation are closely linked. If the instantaneous frequencies of the two modulated signals are equated, it is found that it is possible to use an FM modulator for generating a phase-modulated signal, and likewise it is possible to use a PM modulator for generating a frequency-modulated signal. The relations between the modulating signals are as follows:

$$s'(t) = (D_{pm}/2\pi D_{fm})ds''(t)/dt$$

$$s''(t) = (2\pi D_{fm}/D_{pm}) \int_{-\infty}^{t} s'(t)dt$$

It follows that a PM modulator is equivalent to an FM modulator preceded by a differentiator; on the other hand, an FM modulator is equivalent to a PM modulator preceded by an integrator.

In a similar way it is possible to use a single demodulator for extracting both the FM signal and the PM signal. By cascading together a differentiator and a PM demodulator, an FM demodulation is obtained; finally, by cascading together an integrator and an FM demodulator, a PM demodulation is obtained.

It follows that PM demodulators and FM demodulators are essentially based on the same solutions.

All of what has so far been said corresponds to basic concepts of electrical communications, which are known to all persons skilled in the sector.

For further general information on the subject, useful reference may be made to the following works:

Digital Audio Signal Processing - Udo Zolder - Technical University of Harburg - Hamburg, Germany - John Wiley & Sons;
An Introduction to Analog and Digital Communications - Simon Haykin - McMaster University - John Wiley & Sons;
Analysis and Design of Analog Integrated Circuits - Paul R. Gray and Robert G. Meyer - John Wiley & Sons.

Likewise known is the fact that traditional demodulators of an analog type (in what follows reference will generally be made to frequency demodulators, but the same considerations also apply, *mutatis mutandis*, to phase demodulators) can basically be classified into two categories: direct-type demodulators and indirect-type demodulators.

Direct demodulators find the instantaneous frequency of the signal received and include, for example, frequency discriminators, demodulators with phase-quadrature delay, and zero-crossing detectors. Indirect demodulators, instead, use fedback systems - such as phase-locked loops (PLLs) - for finding the variations in the instantaneous frequency of the input signal.

Frequency discriminators use, for extraction of the modulated signal, a differentiating circuit. The derivative of the signal received consists in fact of a wave modulated in both amplitude and frequency; consequently, by demodulating in amplitude the output of the differentiator, the modulating signal s'(t) transmitted is obtained, but for a constant and a coefficient.

Usually, a balanced structure is implemented (see, in this connection, the first of the works previously cited) which enables elimination of the residual constant.

Given that each variation in the amplitude of the carrier is reproduced at output as a noise superimposed on the desired signal, before differentiation it is necessary to limit the input signal in amplitude with a hard-limiter followed by a band-pass filter for cancelling the harmonics of the carrier frequency.

The output of the frequency discriminator consequently contains noise and distortion terms due to the fact that the blocks designed to implement the circuit do not fully satisfy all the hypotheses assumed in the mathematical model of the demodulator.

In particular:

- the spectrum of the signal received is not strictly band limited, and hence the outputs of the complementary differentiators are noisy;
- the filters that implement the complementary differentiators do not have a clear low-pass characteristic, and hence the output of the amplitude demodulator is distorted;
- the filters do not provide a good approximation to the differentiator throughout the frequency band occupied by the signal received, and hence the characteristic is not perfectly linear and introduces distortions; and
- the matching of the differential structures is not perfect and varies with the temperature and over time.

Demodulators with phase-quadrature delay are based on the beating between the frequency-modulated signal and the same signal rotated by a factor of $\pi/2$. The delay is obtained through a linear-phase network.

By multiplying together the two signals in phase quadrature and neglecting the high-frequency spectral content, the desired demodulated signal is obtained to a good approximation.

The FM demodulator with phase-quadrature delay thus basically consists of a sequence of four elements: once again a limiter with a low-pass filter, a network with linear phase and constant group delay, a multiplier, and a low-pass filter.

Also in this case the output of the demodulator is characterized by distortions due to the non-ideal characteristics of the delay network, to the residual noise of the low-pass filters, as well as to the intrinsic trigonometric approximations assumed on the modulated signal.

The zero-crossing detector measures the number of zero crossings of the frequency-modulated signal to calculate the modulating signal.

Approximately, the instantaneous frequency is inversely proportional to the time interval between two adjacent zero crossings calculated in a measurement time interval T.

The estimation of the instantaneous frequency is reliable only if two conditions are met; namely:

- the modulating signal is basically constant within the interval T; and
- within the measurement interval T there is a high number of zero crossings.

Since, by definition, the instantaneous frequency is proportional to the modulating signal, it is possible to reconstruct this signal by counting the number of zero crossings through the integrator. The quality of the reconstructed signal depends, however, to a large extent upon the precision with which the number of zero crossings is identified and upon the fact that the two conditions specified previously have always been satisfied.

As is known, the PLL is a negative-feedback system made up of three main blocks: a multiplier, a loop filter, and a voltage-controlled oscillator (VCO), the frequency of oscillation of which is proportional to the signal applied at input. When the PLL is locked to a periodic input signal, the frequency of the VCO is identical to that of the input signal, and the phase detector produces a DC voltage or a low-frequency voltage proportional to the phase difference between the input signal and the output signal of the VCO.

If the input frequency changes slightly, the phase difference with respect to the VCO starts to increase continuously. This modifies the control voltage at input to the VCO, so as to bring the oscillation frequency of the VCO back to the same frequency as the new input frequency. As long as the system is locked, the input voltage of the VCO is proportional to the frequency of the input signal. This mode of operation renders the PLL particularly suitable for demodulation of FM signals, where the frequency of the input signal varies over time and contains the desired information.

Since the band of the FM signal is wider than the band of the loop filter and of the blocks that contain the PLL (equal to that of the modulating signal), the PLL has performance levels in terms of noise that are amply superior to those of all the other direct demodulation systems by factors in the region of 10-20 dB.

The main disadvantage of the PLL is represented by its non-negligible complexity as compared to traditional analog solutions.

Completely digital implementation of a PLL is problematical on two main accounts: the stability of the feedback loop and the accuracy of the phase detector. In any case, also entirely digital PLLs use a considerable amount of combinatorial logic and are in practice used, for the applications that are of concern in the present context, in situations in which the ratio between the clock frequency and the band of the modulating signal is considerably higher than unity, which enables simplification of the phase detector by making it simply in the form of a counter.

All the known solutions just described are illustrated in detail in the three works cited previously, to which the reader may refer for more detailed information.

Objects and summary of the present invention

The object of the present invention is to provide a demodulator for demodulation of angle-modulated signals - and hence frequency-modulated (FM) signals or phase-modulated (PM) signals - capable of overcoming the drawbacks of the solutions described previously.

According to the present invention, the above purpose is achieved thanks to a demodulator having the characteristics specifically called for in the claims which follow.

The invention also relates to the corresponding demodulation process, as well as to the corresponding computer program product.

In particular, the solution according to the invention makes it possible to provide a digital demodulator which can be built both in the form of a hardware fully integrated on chip and in the form of a processor suitably programmed without the aid of external calibration circuits or parts.

In the currently preferred embodiment of the invention, also an output digital filter is provided, usable, for example, for de-emphasis of the signal.

The solution according to the invention may be applied to a digital signal sampled indifferently in baseband (BB), or else at intermediate frequency (IF) downstream of a tuner.

The corresponding hardware cell occupies a small area of silicon and can be employed indifferently in applications of a general-purpose type and in applications of a high-end type.

The high quality of the demodulated signal renders the cell suitable for high-end applications, audio-processing systems (for example, CODEC), and battery-supplied portable applications on account of the low power dissipation.

The solution according to the invention overcomes the drawbacks intrinsic in mixed digital-analog systems where the analog part is mainly made up of amplifiers, PLLs and biasing circuits, the power dissipation of which and the area occupied are never negligible. These latter factors are ones which have up to now rendered the compatibility of analog and digital systems critical in chips dedicated to receiving demodulation of audio and video signals.

In particular, the solution according to the invention makes it possible to develop simple and compact implemental solutions that are able to operate with a relatively low clock frequency. The foregoing enables advantages to be achieved that are beyond a traditional analog solution, such as:

- a simple structure, which does not use any feedback or PLLs;
- a small area occupied and a lower cost per unit surface;
- reduced power dissipation;
- lower sensitivity to thermal variations and process variations;
- the possibility of making the RTL code of the cell independent of the technology of the process of fabrication, overcoming the typical drawback of analog solutions, which must be re-designed whenever there is a change in technology or process; and
- flexibility in terms of possible high-end, general-purpose, and low power-absorption applications.

In particular, since the solution according to the invention may be implemented in an entirely digital form, it enables removal altogether of the analog parts of the receiving system, integrating on a single chip the receiving of the signal and its possible processing. The integration also regards the analog mixers typically necessary for bringing an intermediate-frequency (IF) modulated channel into baseband.

Detailed description of the annexed drawings

The invention will now be described, purely by way of non-limiting example, with reference to the attached drawings, in which:

- Figure 1 is a schematic representation, in the form of a vector diagram, of the characteristics of an angle-modulated signal;

- Figure 2 illustrates, in the form of a block diagram, the structure of a frequency demodulator built according to the invention; and
- Figure 3 illustrates, again in the form of a block diagram, the structure of a phase demodulator according to the invention.

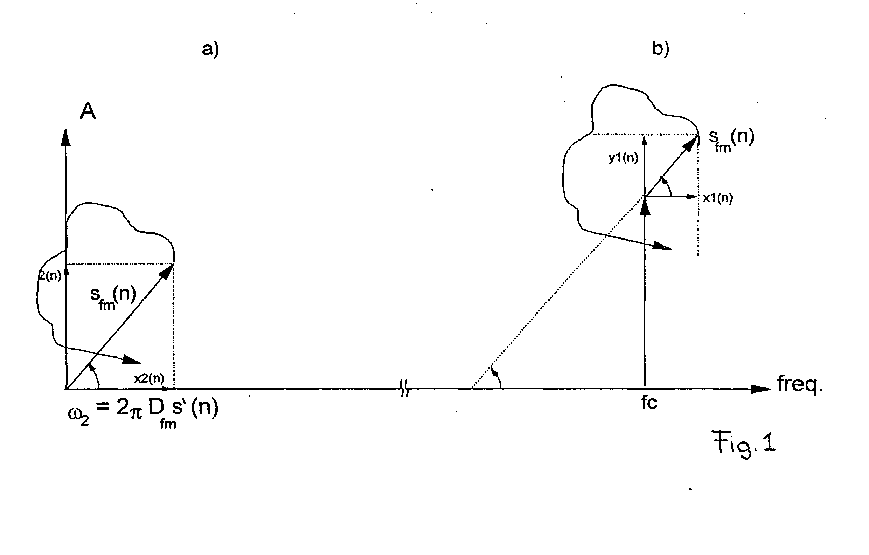

The diagram of Figure 1 illustrates, as a whole, the characteristics of an angle-modulated signal (in the case in point, an FM signal).

In this case, the modulated signal $s_{fm}$ rotates in time in a complex plane with a mean angular frequency $f_c$, given that s'(t) has a zero mean value.

In particular, the diagram of Figure 1 refers both to the signal modulated on a carrier at a frequency $f_c$ other than zero (right-hand part of the figure, designated by b) and to the baseband signal, whereby $f_c = 0$ (left-hand part of the same figure, designated by a).

The demodulation operation corresponds to calculating the variation in the angle subtended by the vector $s_{fm}$ with respect to the real plane.

The operation of taking the channel into baseband and of removing the component $f_c$ corresponds to implementing the following relations:

$$\begin{cases} s_{fm} = A(t) \cdot \cos[2\pi \cdot (f_c + D_{fm} \cdot s'(t))t] \\ s_{fm} = A(t) \cdot e^{j\phi'_{fm}(t)} \\ \phi_{fm} = 2\pi \cdot (f_c + D_{fm} \cdot s'(t))t \end{cases}$$

$$\Rightarrow \begin{cases} s_{fm} = A(t) \cdot \cos[2\pi \cdot (D_{fm} \cdot s'(t))t] \\ s_{fm} = A(t) \cdot e^{j\phi_{fm}(t)} \\ \phi_{fm} = 2\pi \cdot (D_{fm} \cdot s'(t))t \end{cases}$$

The vector $s_{fm}$ rotates in the complex plane with an angular frequency $\omega = 2\pi D_{fm} \cdot s'(t)$, and the amplitude A(t) in general may vary in time on account of the variations in the transmission channel.

The sampled signal $s_{fm(n)}$ is now considered sampled at a sampling frequency $f_s$, and a complex variable $z(n, n-1)$ is defined, which depends upon the signal $s_{fm(n)}$ at the instant n and upon the delayed signal $s_{fm(n-1)}$ conjugated at the instant n - 1.

According to this hypothesis, the information regarding the signal s'(n) is contained in the phase of the complex vector $z(n, n-1) = s_{fm}(n) \cdot s^*_{fm}(n-1)$ just described, according to the following relation:

$$\{ s_{fm}(n) = A(n) \cdot e^{j\phi_{fm}(n)}$$

$$\{ s^*_{fm}(n-1) = A(n-1) \cdot e^{-j\phi_{fm}(n-1)}$$

$$\{ z(n,n-1) = s_{fm}(n) \cdot s^*_{fm}(n-1) \propto e^{j \cdot [\phi_{fm}(n) - \phi_{fm}(n-1)]}$$

$$\{ \angle z(n,n-1) = \phi_{fm}(n) - \phi_{fm}(n-1)$$

The phase of the vector $z(n, n-1)$ approximates the derivative $d\phi_{fm}(t)/dt$ thanks to the first-order finite-difference relation

$$\phi_{fm}(n) - \phi_{fm}(n-1) \rightarrow d\phi_{fm}(t)/dt = s'(n)$$

It follows that a circuit capable of measuring the phase of a vector thus defined functions as a frequency (FM) demodulator.

A particularly efficient implementation is obtained by exploiting Euler's formula which enables representation of a complex variable by means of two orthogonal functions, from which the argument is calculated by resorting to the arctangent (arctan) trigonometric function.

Euler's formula provides a way of representing a complex variable by means of two orthogonal functions, as follows:

$$\{ s(n) = A(n)\cdot\{\cos[\phi_{fm}(n)]+j\cdot\sin[\phi_{fm}(n)] \}$$

$$\{ s^*(n-1) = A(n-1)\cdot\{\cos[\phi_{fm}(n-1)]-j\cdot\sin[\phi_{fm}(n-1)]\}$$

The vector z(n, n -1) is finally decomposed by suitably separating the real parts from the imaginary parts:

$$z(n)\cdot z^*(n-1)\propto\cos[\phi_{fm}(n)]\cdot[\cos[\phi_{fm}(n-1)]+\sin[\phi_{fm}(n)]\cdot\sin[\phi_{fm}(n-1)]+$$

$$j<\sin[\phi_{fm}(n)]\cdot\cos[\phi_{fm}(n-1)]-\cos[\phi_{fm}(n)]\cdot\sin[\phi_{fm}(n-1)]>$$

Separating the vector z(n, n -1) into its orthogonal components x(n, n -1) and y(n, n -1), the signal s'(t) is obtained from the following relation:

$$z(n,n-1) = x(n,n-1)+j\cdot y(n,n-1)$$

$$\{ x(n,n-1) = \cos[\phi_{fm}(n)]\cdot\cos[\phi_{fm}(n-1)]+\sin[\phi_{fm}(n)]\cdot\sin[\phi_{fm}(n-$$

$$y(n,n-1)= \sin[\phi_{fm}(n)]\cdot\cos[\phi_{fm}(n-1)]-\cos[\phi_{fm}(n)]\cdot\sin[\phi_{fm}(n-1)]$$

$$s'(t) = d\phi_{fm}(t)/dt\rightarrow\angle z(n,n-1) = \text{atan } y(n)/x(n)$$

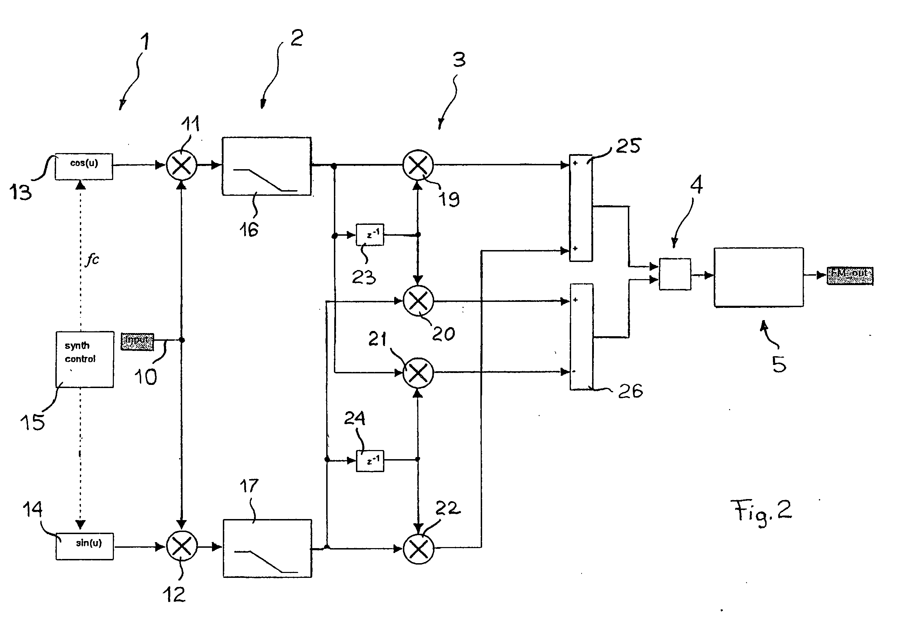

In the diagram of Figure 2 (which regards an FM demodulator), the stage designated as a whole by 1 is designed to demodulate the individual FM channel into baseband, issuing at output two signals in quadrature with respect to one another, x1(n) and y1(n).

For this purpose, the input signal (sampled in general at a frequency $f_s$ to which there corresponds a period $T = 1/f_s$) is supplied on an input line 10 and sent to two mixers (multipliers) 11 and 12, which receive two respective local signals at the frequency of the carrier $f_c$ and in quadrature with respect to one another. The local signals are generated by two synthesis blocks 13 and 14 driven by a synthesis control designated by 15.

The stage designated as a whole by 2 comprises two digital low-pass filters 16, 17, the function of which is to filter the high-frequency image spectra generated by the mixers 11 and 12, limiting the band to that of the FM channel so as to arrive, in practice, at the generation of the two signals in quadrature $\cos \phi(n)$ and $\sin \phi(n)$ seen previously.

The stage designated as a whole by 3 is basically a combinatorial network designed to generate the signals x(n, n -1) and y(n, n -1) corresponding to the two components, the real one and the imaginary one.

The above-mentioned orthogonal components are applied to the stage designated by 4, the function of which is to calculate the arctangent function (arctan) which identifies the demodulated signal s'(t).

Finally, the latter signal is possibly equalized and filtered by the filter constituting the stage 5 (this is usually an infinite impulse response (IIR) filter), the aim of this being to obtain a constant response throughout the channel spectrum, eliminating the out-of-band noise.

Returning now to the illustration of the structure of the stage 3, it may be noted that this stage is basically made up of two sets of additional mixers or multipliers, designated by the progressive numbering 19 to 22, to which two delay lines 23, 24 are associated, as well as two adder blocks 25 and 26.

In particular, the function of the individual mixers is as follows:

- the mixer 19 multiplies together the output signal from the filter 16 with a replication of the above signal delayed by the delay line 23;
- the mixer 20 multiplies together the output signal from the filter 17 with the aforesaid delayed version of the output signal from the filter 16;
- the mixer 21 multiplies together the output signal from the filter 16 with a delayed version (via the delay line 24) of the output signal from the filter 17; and finally,
- the mixer 22 multiplies together the output signal from the filter 17 with the version of the same signal retarded by the delay line 24.

It is to be recalled that preferably the value of retardation of the delay lines 23 and 24 corresponds to the sampling period T.

The adder 25 sums together (with the same sign) the outputs of the mixers 19 and 22, whilst the adder 26 sums together (with opposite sign) the outputs of the mixers 20 and 21, hence calculating the difference.

To appreciate how robust the system just described is, it may be noted that if the channel is not brought into baseband, i.e., if the component $f_c$ is not completely removed, the demodulator described still operates properly, in that the residual systematic error in frequency $f'_c$ may be considered constant in time and is thus cancelled out in the differentiation formula when the arctangent is calculated.

The module 4, which performs this function, may be conveniently implemented in the form of a look-up table, i.e., in the form of a memory, exploiting the characteristics of symmetry of the arctangent function itself.

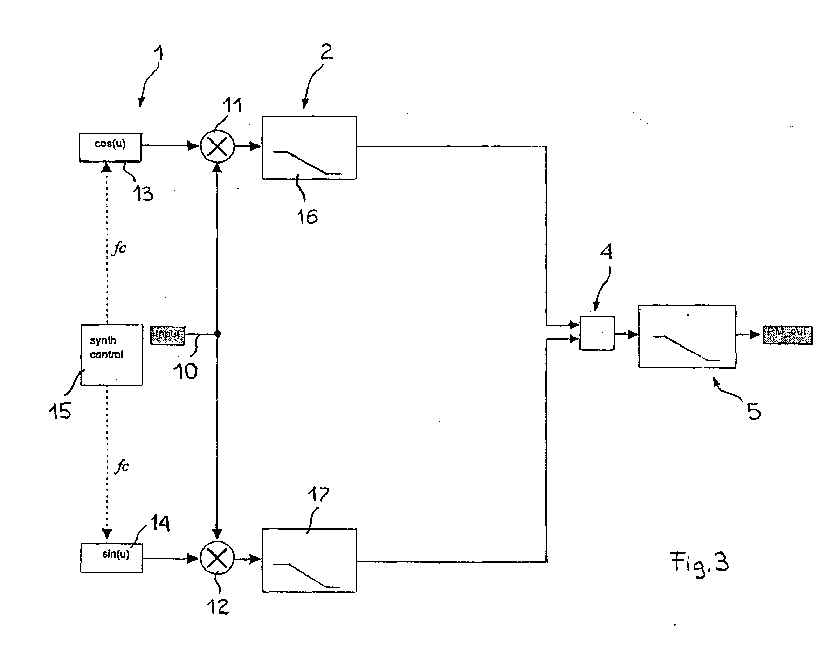

The phase demodulator (PM demodulator) represented in the diagram of Figure 3 may be simply viewed as a simplified version of the FM demodulator represented in Figure 2.

The said simplified version has been obtained by eliminating in practice the stage 3 (in which the information corresponding to the instantaneous variation of the frequency corresponding to the action of frequency modulation is in fact acquired).

Furthermore, the output stage of the PM demodulator of Figure 3 usually consists simply of a low-pass digital filter 5' with a less sophisticated function as compared to the functions performed (de-emphasis, etc.) by the filter 5 of the scheme represented in Figure 2.

From the implementation standpoint, both of the system architectures represented in Figures 2 and 3 process the signals in a sequential way (i.e., according to a pipeline-type logic). For this reason, they are easy to implement either in the form of a dedicated hardware unit or else in the form of a code for a DSP or a microprocessor.

Of course, without prejudice to the principle of the invention, the details of construction and the embodiments may vary widely with respect to what is described and illustrated herein, without thereby departing from the scope of the present invention as defined in the annexed claims.

The above considerations apply in particular (but without being limited thereto) to the possible variants listed below:

- embodiment of the scheme represented in Figure 2 with or without equalization filter;
- embodiment of the scheme represented in Figure 2 (again with or without equalization filter) operating on channel in baseband, hence without the provision of the stage or stages which, in the example illustrated, bring the modulated signal back into baseband;
- transposition of what has just been described to a PM demodulator (Figure 3) which operates both on an intermediate-frequency modulated signal and on a baseband signal;
- utilization, as an alternative to the distinct multipliers represented in the diagrams of Figures 2 and 3, of multipliers capable of operating on a number of signals according to a multiplexer scheme in order to reduce the area occupied even further; and
- possible software implementation of the demodulator.

Obviously, the arctangent function (module 4) can be calculated with more or less sophisticated levels of approximation, the qualitative result of demodulation always being the better, the more refined is the arctangent calculation function.

**Claims**

1. A demodulator for angle-modulated (PM, FM) signals, **characterized in that** it comprises:

   - an input module (10 to 17) for generating, starting from the modulated signal ($s_{fm}$), a first component ($\cos\phi(n)$) and a second component ($\sin\phi(n)$) in quadrature with respect to one another, said components in quadrature being representative of the real part and of the imaginary part of the modulating signal (s'(t); s''(t)) represented as a complex variable; and
   - a processing module (4) able to generate an output signal, calculating the arctangent function of the ratio between said imaginary part and said real part, said output signal identifying the demodulated signal (s'(t) ; s''(t)).

2. The demodulator according to Claim 1, **characterized in that** said first component ($\cos\phi(n)$) and said second

component ($\sin\phi(n)$) in quadrature with respect to one another are generated starting from said digitalized modulated signal ($s_{fm}$).

3. The demodulator according to Claim 1 or Claim 2, for demodulation of signals modulated on a carrier with a frequency ($f_c$) other than zero, **characterized in that** said input module comprises frequency translators (11, 13; 12, 14) for bringing said modulated signal back into the baseband.

4. The demodulator according to Claim 3, **characterized in that** said frequency translators comprise:

   - a generating set (13 to 15) for generating two local signals at the frequency of said carrier ($f_c$) in quadrature with respect to one another; and
   - mixing means (11, 16; 12, 17) for mixing said two local signals with the modulated signal.

5. The demodulator according to any one of Claims 1 to 4, **characterized in that** said input module (10 to 17) carries, associated thereto, at least one filter (16, 17) for low-pass filtering of said first component ($\cos\phi(n)$) and said second component ($\sin\phi(n)$).

6. The demodulator according to any one of Claims 1 to 5, **characterized in that** it comprises an output filter (5, 5') acting on said output signal which identifies the demodulated signal.

7. The demodulator according to Claim 6, **characterized in that** said output filter (5) is an infinite-impulse-response (IIR) filter.

8. The demodulator according Claim 6, **characterized in that** said output filter (5) is a low-pass filter.

9. The demodulator according to any one of the preceding claims, **characterized in that** said processing module (4) is configured as a look-up table.

10. The demodulator according to any one of the preceding claims, for demodulation of phase-modulated (PM) signals, **characterized in that** said processing module (4) acts in a direct way on said first component ($\cos\phi(n)$) and said second component ($\sin\phi(n)$) in quadrature with respect to one another, in the absence of substantial operations of intermediate processing, said first component and said second component in quadrature being representative of said real part and said imaginary part of the modulated signal.

11. The demodulator according to Claim 6 or Claim 7, for demodulation of frequency-modulated (FM) signals modulated with emphasis, **characterized in that** said output filter (5) implements a de-emphasis function.

12. The demodulator according to any one of Claims 1 to 9 or Claim 11, for demodulation of frequency-modulated (FM) signals, **characterized in that** said input module carries, associated thereto, a combiner stage (3) which generates:

   - for each of said components in quadrature ($\cos\phi(n)$, $\sin\phi(n)$), a respective version delayed ($z^{-1}$) in time;
   - the product of each of said components in quadrature with its own delayed version;
   - the cross product of each of said components in quadrature with the version delayed in time of the other component in quadrature;
   - said real part as the sum of the products of each of said components in quadrature with its own delayed version; and
   - said imaginary part as the difference of said cross products.

13. The demodulator according to Claim 12, **characterized in that** it comprises at least one delay element (23, 24) for generating said version delayed in time.

14. The demodulator according to Claim 12 or Claim 13, **characterized in that** it comprises a respective plurality of multipliers (19 to 22) for generating said products.

15. The demodulator according to Claim 12 or Claim 13, **characterized in that** it comprises at least one multiplier for generating said products with multiplexer modalities.

**16.** A process for demodulating angle-modulated (PM, FM) signals, **characterized in that** it comprises the operations of:

- generating, starting from the modulated signal ($s_{fm}$), a first component ($\cos\phi(n)$) and a second component ($\sin\phi(n)$) in quadrature with respect to one another, said components in quadrature being representative of the real part and of the imaginary part of the modulating signal ($s'(t)$; $s''(t)$) represented as a complex variable; and
- generating an output signal, calculating the arctangent function of the ratio between said imaginary part and said real part, said output signal identifying the demodulated signal ($s'(t)$; $s''(t)$).

**17.** The process according to Claim 16, **characterized in that** it comprises the operation of digitalizing said modulated signal ($s_{fm}$).

**18.** The process according to Claim 16 or Claim 17, for demodulation of signals modulated on a carrier with frequency ($f_c$) other than zero, **characterized in that** it comprises the operation of translating in frequency said modulated signal to bring it back into baseband.

**19.** The process according to Claim 17, **characterized in that** it comprises the operations of:

- generating (13 to 15) two local signals at the frequency of said carrier ($f_c$) in quadrature with respect to one another; and
- mixing (11, 16; 12, 17) said two local signals with the modulated signal.

**20.** The process according to any one of Claims 16 to 19, **characterized in that** it comprises the operation of low-pass filtering (16, 17) said first component ($\cos\phi(n)$) and said second component ($\sin\phi(n)$).

**21.** The process according to any one of Claims 16 to 20, **characterized in that** it comprises the operation of filtering (5, 5') said output signal which identifies the demodulated signal.

**22.** The process according to Claim 21, **characterized in that** said operation of filtering the output signal is carried out according to an infinite impulse response (IIR).

**23.** The process according to Claim 21, **characterized in that** said operation of filtering the output signal is carried out as a low-pass filtering function.

**24.** The process according to any one of Claims 16 to 23, **characterized in that** it comprises the operation of implementing said arctangent function as a look-up table.

**25.** The process according to any one of Claims 16 to 24, for demodulation of phase-modulated (PM) signals, **characterized in that** it comprises the operation of calculating said arctangent function directly, starting from said first component ($\cos\phi(n)$) and said second component ($\sin\phi(n)$) in quadrature with respect to one another, in the absence of substantial operations of intermediate processing, said first component and said second component in quadrature being representative of said real part and said imaginary part of the modulated signal.

**26.** The process according to Claim 21 or Claim 22, for demodulation of frequency-modulated (FM) signals modulated with emphasis, **characterized in that** it comprises the operation of implementing, in the context of said action of output filtering, a de-emphasis action.

**27.** The process according to any one of Claims 16 to 24 or Claim 26, for demodulation of frequency-modulated (FM) signals, **characterized in that** it comprises the operations of generating:

- for each of said components in quadrature ($\cos\phi(n)$, $\sin\phi(n)$), a respective version delayed ($z^{-1}$) in time;
- the product of each of said components in quadrature with its own delayed version;
- the cross product of each of said components in quadrature with the version delayed in time of the other component in quadrature;
- said real part as the sum of the products of each of said components in quadrature with its own delayed version; and
- said imaginary part as the difference of said cross products.

28. A computer program product directly loadable in the internal memory of a digital computer and comprising software code portions for performing the operations according to any one of Claims 16 to 27 when said product is run on a computer.

Fig. 1

EP 1 217 724 A1

Fig. 2

EP 1 217 724 A1

Fig.3

**European Patent Office**

**EUROPEAN SEARCH REPORT**

Application Number

EP 00 83 0838

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 517 689 A (M. HAYASHIHARA) 14 May 1996 (1996-05-14) * column 7, line 13 - column 9, line 12; figures 1,2,16 * | 1-28 | H03D3/00 |
| X | US 4 750 214 A (B. HART) 7 June 1988 (1988-06-07) * column 2, line 40 - column 5, line 51; figures 1,2 * | 1-28 | |
| X | US 5 068 876 A (S. YOSHIKAWA) 26 November 1991 (1991-11-26) * column 1, line 14 - line 68; figures 1,2 * | 1-28 | |
| X | EP 0 617 507 A (ANT NACHRICHTENTECHNIK GMBH) 28 September 1994 (1994-09-28) * page 3, line 22 - page 4, line 17; figure 5 * | 1 | |
| X | EP 0 695 028 A (MATSUSHITA CO .) 31 January 1996 (1996-01-31) * page 2, line 19 - page 3, line 16; figure 1 * | 1 | TECHNICAL FIELDS SEARCHED (Int.Cl.7) H03D |

The present search report has been drawn up for all claims

| Place of search | Date of completion of the search | Examiner |
|---|---|---|
| THE HAGUE | 7 June 2001 | Butler, N |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 00 83 0838

This annex lists the patent family members relating to the patent documents cited in the above-mentioned European search report.
The members are as contained in the European Patent Office EDP file on
The European Patent Office is in no way liable for these particulars which are merely given for the purpose of information.

07-06-2001

| Patent document cited in search report | | Publication date | Patent family member(s) | | Publication date |
|---|---|---|---|---|---|
| US 5517689 | A | 14-05-1996 | JP | 6077737 A | 18-03-1994 |
| US 4750214 | A | 07-06-1988 | NONE | | |
| US 5068876 | A | 26-11-1991 | JP | 1254040 A | 11-10-1989 |
| EP 617507 | A | 28-09-1994 | DE | 4309684 A | 29-09-1994 |
| | | | AT | 168837 T | 15-08-1998 |
| | | | ES | 2118995 T | 01-10-1998 |
| EP 695028 | A | 31-01-1996 | JP | 8046657 A | 16-02-1996 |
| | | | CA | 2154646 A | 28-01-1996 |
| | | | US | 5712879 A | 27-01-1998 |

EPO FORM P0459

For more details about this annex : see Official Journal of the European Patent Office, No. 12/82